# EUROPEAN PATENT SPECIFICATION

(11) **EP 1 672 645 B1**
(45) Date of publication and mention of the grant of the patent: **04.11.2009**
(21) Application number: 05027285.5
(22) Date of filing: 14.12.2005
(51) Int. Cl.: G11C 16/04, H01L 21/8247, H01L 27/115

(54) **Electronic memory device having high density non volatile memory cells and a reduced capacitive interference cell-to-cell**
Elektronische Speichervorrichtung mit nichtflüchtigen Speicherzellen mit hoher Dichte und verringerter kapazitiver Zelle-zu-Zelle-Interferenz
Dispositif de mémoire électronique ayant des cellules de mémoire non volatiles à densité élevée et une interférence capacitive réduite cellule-à-cellule

(30) Priority: 14.12.2004 IT MI20042373
(43) Date of publication of application: 21.06.2006
(73) Proprietor: STMicroelectronics S.r.l., 20041 Agrate Brianza (Milano) (IT)
(72) Inventor: Khouri, Osama, 20146 Milano (IT); Caimi, Carlo, 20092 Cinisello Balsamo (Milano) (IT); Mastrodomenico, Giovanni, 20059 Vimercate (Milano) (IT); Caprara, Paolo, 20162 Milano (IT)
(74) Representative: Niederkofler, Oswald

(56) References cited:
- EP-A- 1 435 657
- US-A1- 2003 201 487
- US-A1- 2003 210 582
- US-A1- 2004 232 496

## Description

### Field of application

The present invention relates to an electronic memory device comprising non-volatile memory cells with floating gate and having high density and reduced capacitive coupling interference cell-to-cell.

More specifically the invention relates to an electronic memory device comprising non-volatile memory cells integrated on a semiconductor substrate and comprising a plurality of cells organised in a matrix with rows and columns of cells.

The invention relates, more in particular but not exclusively, to memory cells of the Flash NAND type and the following description is made with reference to this field of application by way of illustration only.

### Prior art

As it is well known, non-volatile electronic memory devices are widely used in several apparatuses, such as cell phones, digital cameras, notebooks, etc., where storing a considerable amount of information in a compact support with high capacity is required.

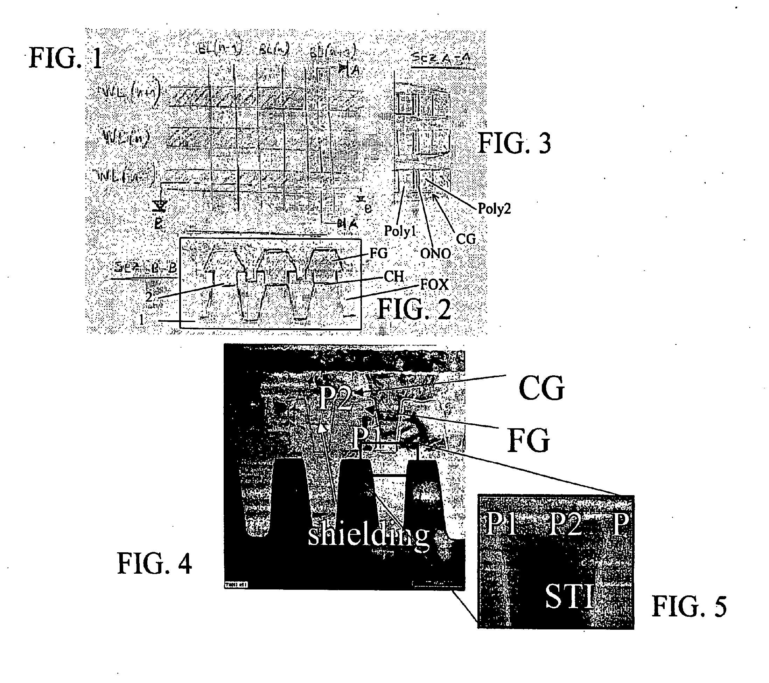

Thus, semiconductor-integrated non-volatile memory devices have been developed, which comprise a plurality of memory cells organised in a matrix, i.e. the cells are organised in rows, called Word lines or WL, and columns, called Bit lines or BL as shown in figure 1.

The memory cells or active areas are realised, as partially shown in figure 2, in a semiconductor substrate 1 separated from each other by portions of a field oxide layer FOX.

Each cell comprises a floating gate transistor with a floating gate region FG realised above a channel region CH or tunnel oxide formed in the semiconductor substrate 1. The floating gate regions FG are separated from one another along the Word Lines, as highlighted in the section of figure 4 and in the detail of figure 5, by a STI layer and by the following Layers P1 made for example of ONO (Oxide, nitride, oxide), P2 made of conductive Shield such as for example polysilicon and P1 for example ONO.

A control gate region CG is then capacitively coupled to the floating gate region by means, for example, of an interposition of more dielectric layers overlapped to form a layer of the ONO type (oxide/nitride/oxide) as shown in figure 3.

Each cell thus has drain, source and body regions. Naturally, in a matrix-like organisation, by means of metallic electrodes, only the drain of the select transistor is contacted near the last cell of the Bit Line, i.e. the DSL and the source of the transistor near the first cell of the Bit Line called SSL.

The control gate regions are thus contacted so as to apply predetermined voltage values to the memory cells.

The charge stored in the floating gate region FG determines the logic state of the cell modifying its threshold voltage. The main feature of the memory cell is that of having two states, one with low or "erased" threshold voltage, which corresponds to an "erased" cell, and one with high or "programmed" threshold voltage which corresponds to a "written" cell. Different conventions can be naturally provided. The voltage is applied from the outside through the control gate region CG but the electrode effectively controlling the state of the channel is the floating gate region FG.

The need of storing, in a more and more reduced space, a greater and greater amount of data has led to the development of devices with multilevel memory cells, wherein different logic states are stored in each cell.

For the devices with multilvel memory cells, and in particular with cells of the Flash NAND type, the accurate control of the threshold distributions of the cells becomes fundamental so that these ones are correctly placed below the erase verify potential, for the erased cells, and between the program verify values and the Vpass programmed values for the written cells. The Vpass voltages are the threshold values relative to the voltages associated with the different logic states stored and their value depends on the number of Bits that can be stored in the same cell.

During the programming of a Flash NAND cell a lot of attention must be paid to the presence of the effective disturbances which could vary the voltage stored in the cell and cause a variation of the voltages stored in the adjacent cells, phenomenon also called "widening of the distributions".

In non-volatile memory devices the undesired capacitive couplings cell-to-cell are among the main responsible for the so called "widening of the distributions". Naturally, in multilevel devices the "widening of the distributions" is more damaging being the thresholds relative to the different values or logic states separated within narrow voltage intervals.

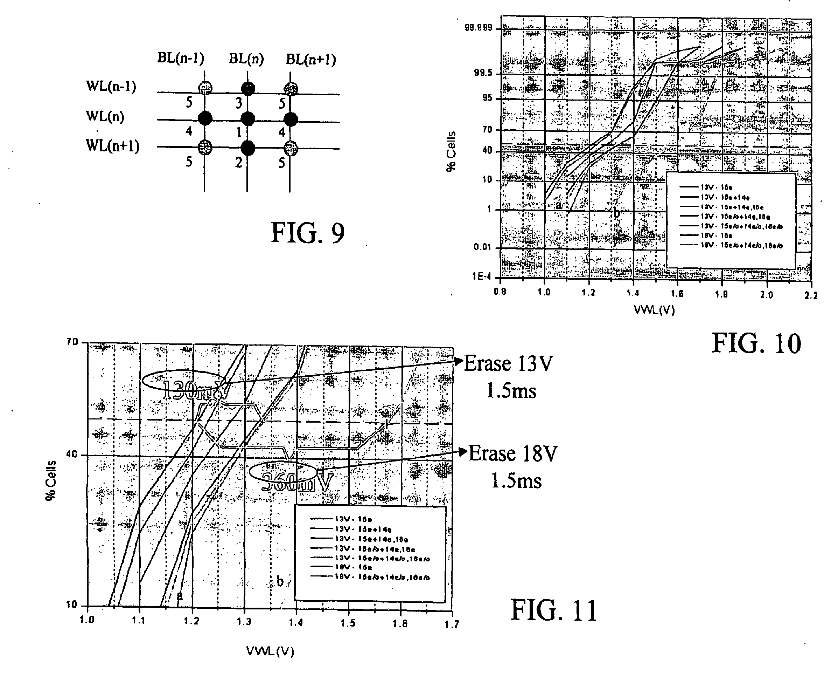

In a memory of the Flash NAND type, with high density, the main parasite capacitive components are identified, with reference to figure 9, with the capacities along:
1. the direction Y of the Bit Lines;
2. the direction X of the Word lines;
3. direction XY diagonal couplings.

The three parasite capacities identified show different values from each other and, typically in the order indicated, they show decreasing values.

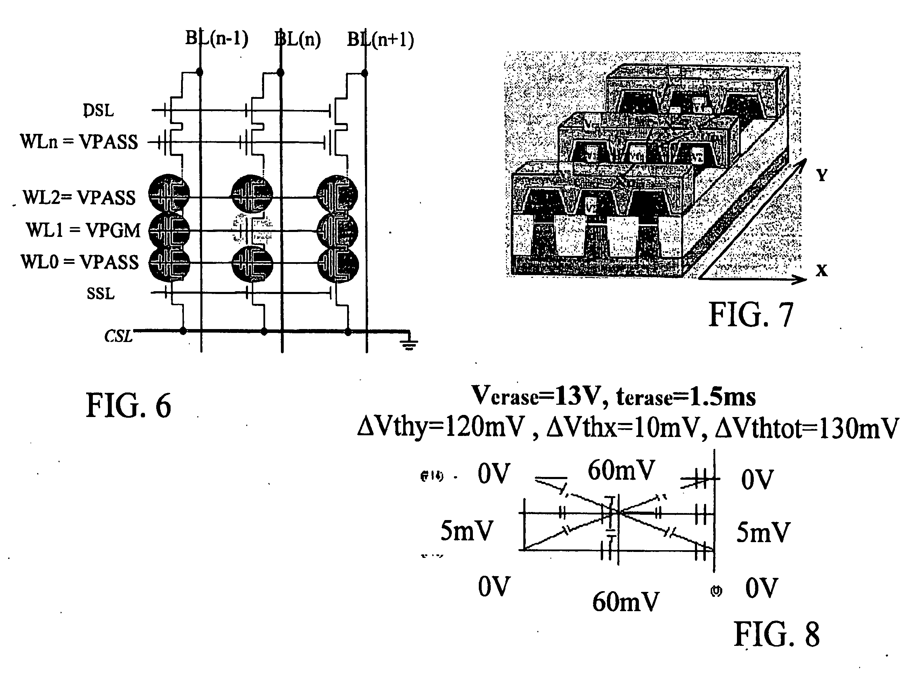

Problems of modification of the voltages in the cells and thus of "widening of the distributions" show up when the cells themselves are programmed. In fact, with particular reference to figure 6, during the programming of the cells blackened in the drawing there is a modification of the voltages of the corresponding floating gate regions which allow the formation of parasite capacities causing a variation of the voltage of the floating gate regions FG of the cell arranged centrally, not blackened in the drawing (WL1-BL(n)).

From some experimental data detected by the Applicant and reported in figures 7 to 10, it has been possible to observe, on a block of a non-volatile memory device totally comprising nine cells, the structure of the parasite capacities and to carry out a measuring thereof.

In the example shown in figure 7, considering the central cell as the detecting one and considering that the adjacent cells had been erased by means of a voltage equal to 13V and programmed with ISPP process, i.e. with a ΔVₛₜₑₚ= 0,5V and tₛₜₑₚ=20µs, a total value of the threshold value has resulte, due to all the parasite capacities which have been formed, equal to 130mV which is of course a relevant value.

On the same block of cells, moreover, two different measurements of the parasite capacities have been detected further to two different formulation and reported in figures 10 and 11.

For the first detection the block of cells had been erased with an "erase verify" value of about 13V in a time t=1,5ms, while for the second detection the "erase verify" erase value was of about 18V in a time t=1,5ms. For both the detections a programming sequence of the cells has been followed corresponding to the increasing numbers indicated from 1 to 5 in figure 9.

In figure 10 the values of the total coupling effect on the cells are reported, measured in threshold voltage, due to the parasite capacities. As it can be seen the curve indicated with the letter a represents the progress of the threshold voltage due to the coupling capacities of the cells which had initial voltage values lower than Vthₛₜₐᵣₜ≤-0,7V, which, according to the current standards, occur with "erase verify" values equal to 13V. With the letter b the curve is instead indicated when the cells have initial voltage values lower than Vthₛₜₐᵣₜ≤-4V i.e. with "erase verify" values equal to 18V.

Figure 11 shows an enlargement of the diagram of figure 10 and the cells highlighted in the same row have been programmed by means of ISPP i.e. with identical values of ΔVₛₜₑₚ= 0,5V and tₛₜₑₚ=20µs. As it can be observed from this enlargement, the threshold voltage is transferred to the "central" cell and it is due to the totality of the parasite capacities and it is equal to 130mV during the first detection according to the curve a, and it is equal to 360mV during the second detection i.e. curve b.

This confirms how the value of the parasite capacities remarkably influences the threshold voltages of the single cells and thus the correctness of the programmable and programmed values.

To try and reduce the capacities of type 2, along the direction X of the Word lines, in the devices of non-volatile memory cells, several solutions are known.

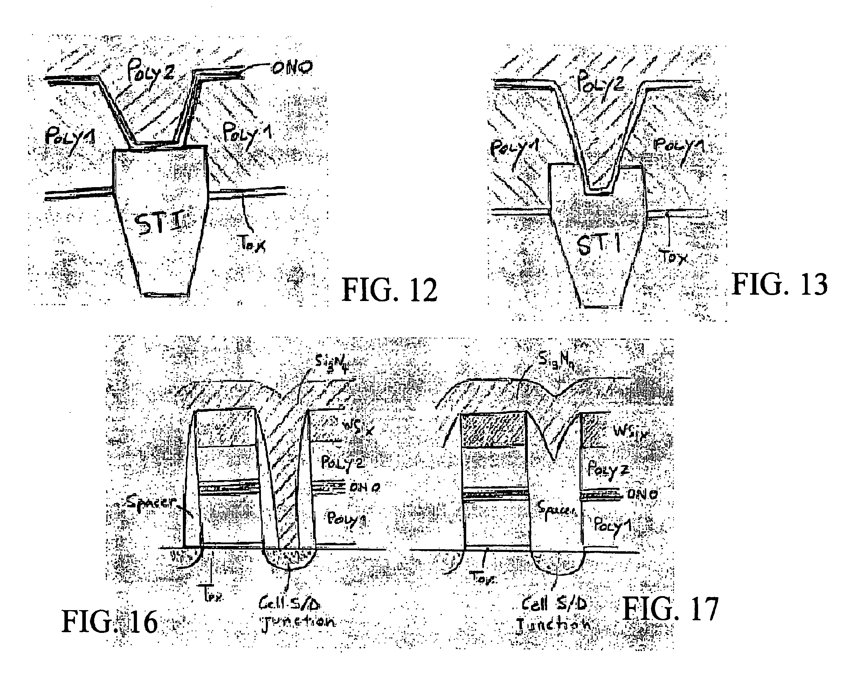

A simple and efficient solution is for example shown in the European patent application No. 02425805.5 to the same Applicant which provides to fill in the space between two adjacent floating gate regions of cells belonging to the same Word lines, with a material having low dielectric constant, solution shown in figure 12.

A further known solution is shown in the US patent application No. 2004/0012998 to Chien et al., which provides to reduce the capacitive effects of the floating gate regions along the direction of the Word lines, thanks to a particular conformation of the Word lines themselves in correspondence with an insulating layer or gate oxide or STI, interposed between two adjacent floating gate regions FG. The solution, shown in figure 13, provides to carry out a trench in correspondence with the insulation layer or STI allowing to increase the laterally insulation between the floating gate regions and to increase the volume and the area interposed between the floating gate regions and the Word lines.

All these solutions allow to remarkably reduce the parasite capacities in the direction X, however they do not give any teachings to reduce the parasite capacities along the axis Y.

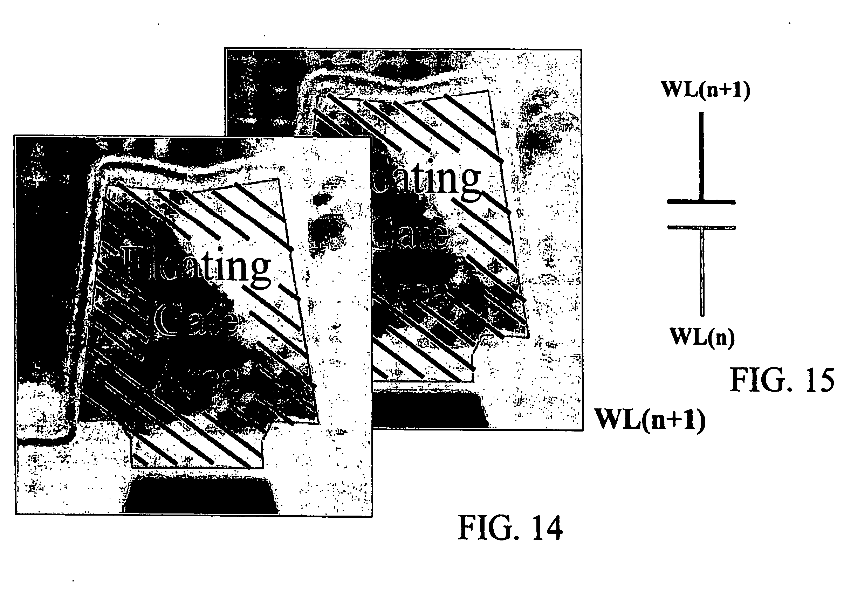

The parasite capacitive coupling which is realised along the axis Y is due to the fact that between the Word lines an insulating layer is interposed and that two opposite floating gate regions FG, arranged on two consecutive Word lines, realise two plates of one capacity, as highlighted in figures 14 and 15.

This phenomenon naturally has increased along with the increase of the density of the memory cells on a same device and thus along with the decrease of the distance between the floating gates of cells placed on opposite Word lines.

To limit the couplings in the direction Y techniques of the dimensional type can be used by varying the geometric dimensions of the floating gate regions. For example a technique provides to reduce the height of the floating gate regions thus reducing the opposite surface.

These solutions however show some drawbacks, in fact, the designation of the dimensions of the floating gate regions influences the programming voltage value and the threshold values which are, especially in the case of a multilevel memory cell device, important values for the operation of the device itself. It is thus necessary not to excessively reduce the dimensions of the floating gate regions.

A further known solution to reduce the parasite capacities between the floating gate regions is that of using programming techniques of the non-volatile memory devices with ramp voltages.

The main drawback of this solution is due to the fact that high programming voltages are required.

A further known solution is that of avoiding the interposition, between the Word lines, of materials with high dielectric constants, such as for example silicon nitride, or trying and reducing the amount of interposed dielectric.

Generally, as highlighted in figure 16, the floating gate regions of non-volatile cell memory devices have lateral spacers partially overhanging the source and drain regions of the present n-mos and p-mos transistors, which are covered by a dielectric layer.

To reduce the amount of dielectric material interposed between the Word lines a know solution provides to increase the length of the spacers, as for example highlighted in figure 17, so that between two opposite floating gate regions, arranged on consecutive Word lines, there is at least a partial union between the spacers.

This solution however shows the drawback that the spacers influence, in a fundamental way, the circuitry of the device and it is thus necessary to take into account the final length of the spacers in relation with the breakdown feature of the present n-mos and p-mos transistors.

A further known solution is shown in the US patent application No. 2004/0232496 to Chen et al., which discloses the use of voids between adjacent charge storage elements in semiconductor structures as flash EEPROM or other type of memory cell array. The adjacent change storage elements are isolated by forming between them a dielectric that contains the void, in turn including the gas present in the processing chamber when the dielectric is formed, which gas has a dielectric constant like 1.0.

The technical problem underlying the present invention is that of providing a non-volatile memory cell device of the Flash NAND type, organised in matrixes, having such structural and functional characteristics as to allow to reduce the capacitive coupling between opposite floating gate regions, along consecutive Word lines, overcoming the drawbacks of the devices realised according to the prior art.

### Summary of the invention

The solution idea underlying the present invention is that of providing a biased or floating conductive shield interposed between the rows or Word lines of the matrix.

On the basis of this solution idea the technical problem is solved by a non-volatile memory cell device as previously indicated and defined by the characterising part of claim 1.

The characteristics and the advantages of the device according to the invention will be apparent from the following description of an embodiment thereof given by way of indicative and non limiting example with reference to the annexed drawings.

### Brief description of the drawings

In these drawings:
Figures 1, 2 and 3 schematically show, respectively, a view from above, a section along the axis A-A of figure 1 and a section along the axis B-B of figure 1 of a portion of non-volatile memory device of the known type;
Figures 4 and 5 respectively show a section portion along a Word Line, through the microscope, of a memory device realised according to the prior art and an enlarged detail between two consecutive Floating gates;
Figure 6 shows an electric circuit corresponding to a portion of a memory device realised according to the prior art;
Figures 7 and 8 respectively show a three-quarter view and the corresponding electric circuit of a portion of a device realised according to the prior art;
Figures 9, 10 and 11 respectively show an exemplary scheme of a device portion comprising nine memory cells identified by Word lines and Bit lines, a diagram reporting the voltage of the Word lines according to the percentages of stored cells and an enlargement of this diagram;
Figures 12 and 13 show portions of two memory devices realised according to the different known techniques;
Figures 14 and 15 respectively show a schematised portion of two opposite floating gate regions belonging to two consecutive Word lines of a memory device realised according to the prior art and the respective electric circuit;
Figures 16 and 17 show two portions in section realised along the Bit lines of a memory device obtained according to two different known techniques;
Figures 18 and 19 show portions of a memory device realised according to the present invention;
Figure 20 shows a perspective portion of a memory device according to a non complete representation wherein the Word lines and the floating gate regions are highlighted;
Figure 21 shows a further embodiment of a device realised according to the present invention;
Figures 22 and 23 show portions of a device realised according to a further embodiment of the present invention;
Figure 24 shows a view from above of a memory device realised according to the present invention.

### Detailed description

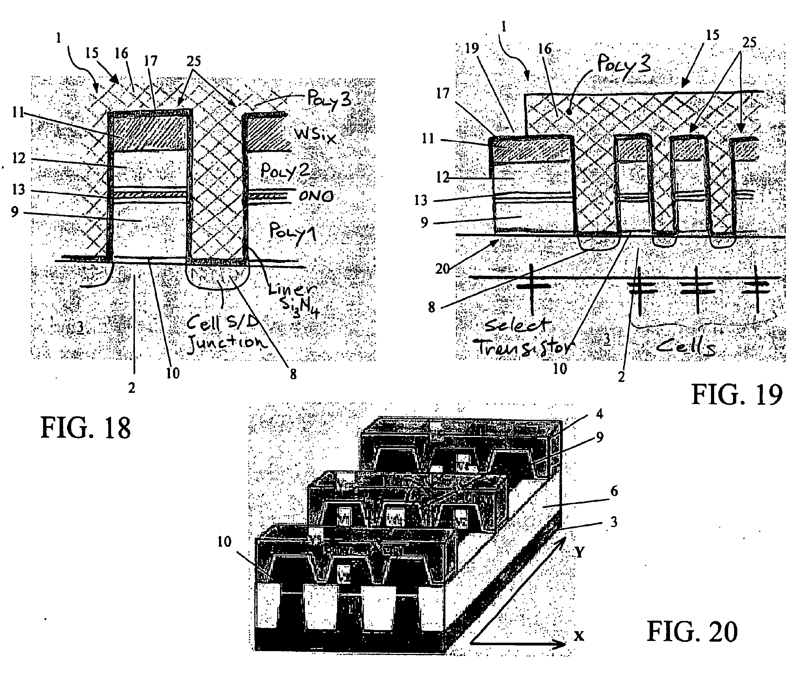

With reference to figures 18 and 19 a portion 1 is described of a non-volatile memory device, having a high density, integrated on a semiconductor substrate 3 of the type comprising a plurality of non-volatile Flash NAND memory cells 2 organised in matrix.

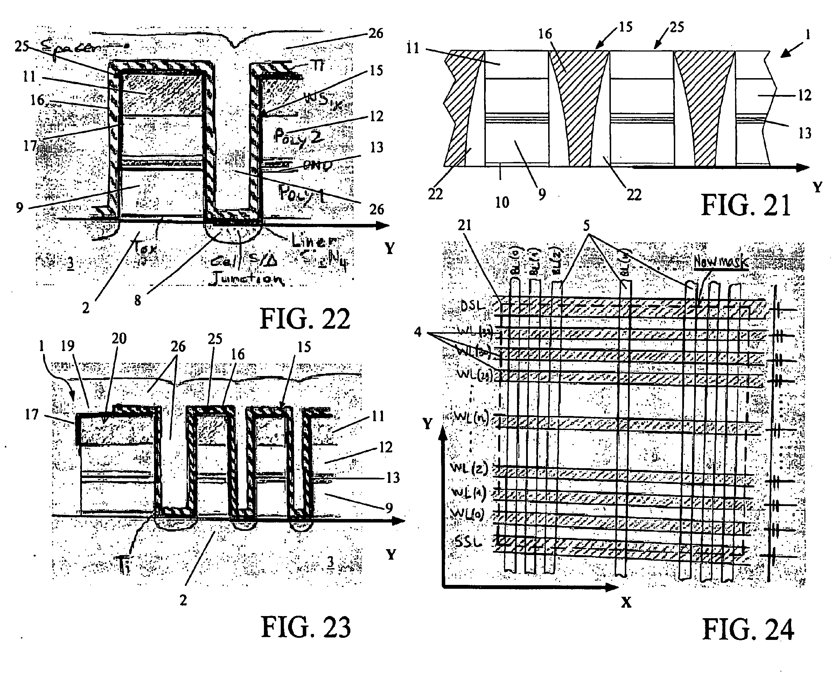

This matrix comprising a plurality of rows or Word lines 4, arranged according to the realisation of figure 24 along the direction X, and columns or Bit lines 5, arranged along the direction Y.

These Word lines 4 and Bit lines 5 unequivocably identify each non-volatile memory cell 2 in the matrix realised in the substrate 3.

The device 1 comprises, as highlighted in figure 20, a plurality of STI 6 projecting from said substrate 3 and organised in columns along the direction Y in parallel to said Bit lines 5.

Each cell 2 comprises a transistor of the MOS type with floating gate it and has, along the direction X, as shown in figure 20, a floating gate region 9 realised above a channel region 10, interposed between two consecutive insulating layers or STI 6.

A control gate region 12 is capacitively coupled to the floating gate region 9, as highlighted in particular in figure 18, through an overlapping of one or more dielectric layers 13 as for example ONO (oxide/nitride/oxide). A silicide layer WSix 11 placed above the control gate region 12 defines a plurality of structures 25.

Each cell 2 also comprises a floating gate transistor, with architecture of the Nand type, which has a body region, non identified in the figures, and a source-drain junction 8 realised in correspondence with the direction Y, of figure 20, interposed between the structures 25 placed on consecutive Word lines 4 in correspondence with each Bit line 5.

Advantageously, according to the invention, a coating 15 is present above the structures 25, the control gates 12, the floating gate regions 9 and the source-drain junctions 8 in the direction Y of the Bit lines 5 realised starting from the substrate 3.

This coating 15 comprises at least one conductive layer 16 which can be floating or suitably biased.

Advantageously, according to the present embodiment, the coating 15 also comprises a thin insulating layer 17 interposed between the upper surface of the substrate 3 and the conductive layer 16 which serves as shield between the two opposite structures 25 arranged in two consecutive Word lines 4 as shown in figure 18. Moreover, the thin insulating layer 17 avoids possible short-circuits between the substrate 3 and the overlapped conductive layer 16.

The thin insulating layer 17 can for example have a thickness value of about 100 Angstrom, naturally this value can vary according to the technology and to the techniques used.

Suitably, the thin insulating layer 17 laterally covers each structure 25 along the Bit lines 5 allowing to insulate in particular each floating gate region 9 laterally in the direction Y.

Suitably, moreover, the conductive layer 16 arranged above the thin insulating layer 17, suitably floating or biased, interposed between the opposite floating gate regions 9, along the direction Y, allows to minimise or to eliminate the capacitive couplings along the Bit Lines 5. The conductive layer 16 can be for example, but not exclusively, a polysilicon layer such as titanium, or a suitably doped polysilicon, or a refractory metal being thermally compatible with the process and the technology suitable to realise the device 1.

The thin insulating layer 17 can be a silicon nitride, a silicon oxide or other insulating material compatible with the realisation process and the technology used.

Moreover, the thin insulating layer 17 can be obtained by means of a deposition or growing process.

Thus, advantageously, the coating 15 creates a conductive shield which allows to realise a capacitive partition of the parasite capacities which could be realised between the opposite floating gate regions 9 arranged on consecutive Word lines 4 and this allows to remarkably reduce the total capacity in the direction Y.

To realise the suitable circuitry elements for example, as shown in figure 19, above a select transistor 20, the conductive layer 16 can be removed by means of a removal process realising upper contact areas 19 accessible from the outside.

The coating 15 is realised on the matrix and in particular preferably on the Word Lines 4 along the Bit Lines 5 and on part of the select transistors 20 along the direction Y except from the contact points which, as known in non-volatile memory devices 1 organised in matrix, are arranged in correspondence with the peripheral edge 21 as shown in figure 24. The present invention is suitable for remarkable variations, all falling within the same protective scope, for example in figure 21 a further embodiment is highlighted. Hereafter in the description the same numbers as those previously used to identify corresponding parts will be used.

A non-volatile memory device 1 organised in matrix, Word lines and Bit lines, has a plurality of structures 25 above described and of the type comprising floating gate regions 9, realised above a channel region 10. Each structure 25 comprises a control gate region 12 capacitively coupled to the floating gate region 9 through an overlapping of one or more dielectric layers 13 as for example ONO (oxide/nitride/oxide). Each structure 25 comprises, above the control gate region 12, a silicide layer 11.

Laterally, each structure 25 comprises a plurality of spacers 22 which, in plan, are arranged in parallel to the direction X of the Word lines. The direction X in figure 21 is not indicated but it is perpendicular to the plan of the drawing itself while the direction Y of the Bit lines is indicated.

The spacers 22 allow to realise, for the device 1, a so called LDD structure in circuitry.

Advantageously, a coating 15 laterally covers, along the direction Y, and possibly in the upper part, each structure 25.

This coating 15 comprises a conductive layer 16, which occupies all the space interposed between the spacers 22 of the opposite structures 25 along the direction Y and placed on consecutive Word lines.

Advantageously, thus, between the opposite floating gate regions 9 along the direction Y, the conductive layer 16 is interposed between insulating spacers 22.

In particular in this embodiment the conductive layer 16, of the coating 15, creates, together with the spacers 22, a conductive shield which allows to realise a capacitive partition of the capacities remarkably reducing the total parasite capacity in the direction Y.

To complete the device 1, by means of the known technique, the conductive layer 16, together with the circuitry structure are planarised by means of a process called CMP which allows to make the device 1 morphologically compatible with the successive process steps.

A further embodiment is shown in figures 22 and 23, according to this embodiment, a non-volatile memory device 1 integrated on a semiconductor 3 and organised in matrix, Word lines and Bit lines, has a plurality of non-volatile memory cells 2.

The device 1 along the direction Y comprises a plurality of structures 25, of the above described type, each one comprising a floating gate region 9 capacitively coupled to an upper control gate 12 by means of one or more dielectric layers 13 and a silicide layer 11 arranged on top.

Each cell 2 also comprises a floating gate transistor, with architecture of the Nand type, which has a body region, not identified in the figures, and a source-drain junction 8 realised in correspondence with the direction Y interposed between a structure 25 and the successive one.

Advantageously along the direction Y a continuous coating 15 is present, arranged on the matrix above the substrate 3 at least along the Bit lines and on part of the selectors realised for the contact, see figures 23 and 24.

The coating 15 comprises at least one continuous conductive layer 16 which covers, in a shaped way, along the direction Y, the plurality of structure 25 and the interposed source-drain junctions 8.

The shaped conductive layer 16 laterally covers, along the direction Y, the plurality of structures 25 and in particular the floating gates 9.

The conductive layer 16 can be for example a titanium layer, but it could be realised also with different conductive material according to the technologies used. Suitably, the coating 15 also comprises at least one thin insulating layer 17 interposed between the upper surface of the substrate 3 and the shaped conductive layer 16 to avoid possible contacts.

According to this embodiment, a suitable continuous spacer layer 26 is present above the coating 15. In particular the spacer layer 26 suitably covers the gap between each structure 25 and the successive one along the direction Y above the source-drain junctions 8, and possibly suitably covering the structures 25.

The coating 15 defines, also in this embodiment, a conductive shield between the opposite floating gate regions 9 and thus realises a physical separation between the floating gate regions remarkably reducing the parasite capacities in the direction Y along the Bit lines.

Possibly in presence of select transistors 20 it is possible, by means of a removal process, to remove the conductive layer 16 for realising the suitable circuitry elements, as shown in figure 23.

The non-volatile memory cell device realised by means of the present invention has a coating 15 or conductive or floating shield which allows to remarkably limit the parasite capacities which would have to be created between the floating gate regions 9 arranged on consecutive Word lines 4 along the direction of the Bit lines 5, i.e. along the direction Y, and it allows to remarkably reduce the interaction and disturbance problems both in the storing and erasing or reading step of the values inserted in the cells 2.

## Claims

1. Electronic memory device comprising non-volatile memory cells, having a high density and reduced interference cell-to-cell, of the type integrated on a semiconductor substrate (3) and organised in matrix with rows or Word lines (4) and columns or Bit lines (5) of memory cells (2), each of said cells (2) comprising at least one floating gate transistor having a floating gate region (9) projecting from said substrate (3) and a control gate region (12) capacitively coupled to said floating gate region (9), wherein between said cells (2) of consecutive Word lines (4) a lateral coating (15) is provided, **characterized in that** said lateral coating comprises at least one floating conductive layer (16) and one thin insulation layer (17), said thin insulation layer (17) being interposed between the upper surface of the semiconductor substrate (3) and said floating conductive layer (16).

2. Device according to claim 1, **characterised in that** said coating (15) is laterally shaped on said cells (2) along the direction of said Bit lines (5).

3. Device according to claim 1, **characterised in that** said coating (15) is shaped on said Word lines (4) along the direction of said Bit lines (5).

4. Device according to one or more of the preceding claims, **characterised in that** said thin insulating layer (17) is interposed between said floating gate regions (9) and said at least one conductive layer (16) along the direction of said Bit lines (5).

5. Device according to claim 1 or 4, comprising a silicide layer (11) arranged above said control gate regions (12) realising with said underlying floating gate regions (9) a plurality of structures (25) having lateral spacers (22) in the direction of said Bit lines (5) **characterised in that** said coating (15) covers above and/or laterally said structures (25) and/or said spacers (22).

6. Device according to claim 1 or 4, comprising a silicide layer (11) arranged above said control gate regions (12) realising with said floating gate regions (9) a plurality of structures (25) **characterised in that** said coating (15) covers at least laterally said structures (25), said coating (15) comprising said thin insulating layer (17) and said conductive layer (16) shaped laterally to said underlying structures (25) in the direction of said Bit lines (5) and **in that** it has a spacer layer (26) arranged above said coating (15) completely covering said substrate (3).

7. Device according to one or more of the preceding claims, of the type comprising select transistors (20) **characterised in that** said coating (15) partially covers said select transistors (20).

8. Device according to one or more of the preceding claims, **characterised in that** said conductive layer (16) is a polysilicon layer.

9. Device according to one or more of the preceding claims, **characterised in that** said conductive layer (16) is a refractory metal.

10. Device according to one or more of the preceding claims, **characterised in that** said conductive layer (16) is a titanium layer.

11. Device according to one or more of the preceding claims, **characterised in that** said thin insulating layer (17) is a silicon nitride.

12. Device according to one or more of the preceding claims, **characterised in that** said thin insulating layer (17) is a silicon oxide.

13. Device according to one or more of the preceding claims, **characterised in that** said thin insulating layer (17) is obtained by means of a deposition process.

14. Device according to one or more of the preceding claims, **characterised in that** said thin insulating layer (17) is obtained by means of a growing process.

## Patentansprüche

1. Elektronische Speichervorrichtung, umfassend nicht flüchtige Speicherzellen, die eine hohe Dichte und reduzierte Interferenz von Zelle zu Zelle aufweisen, der Art, die auf einem Halbleitersubstrat (3) integriert und als Matrix mit Reihen oder Wortleitungen (4) und Spalten oder Bitleitungen (5) von Speicherzellen (2) organisiert sind, wobei jede der Zellen (2) wenigstens einen Floating-Gate-Transistor umfasst, der einen Floating-Gate-Bereich (9) aufweist, der sich von dem Substrat (3) erstreckt, und einen Steuer-Gate-Bereich (12) aufweist, der mit dem Floating-Gate-Bereich (9) kapazitiv gekoppelt ist, wobei zwischen den Zellen (2) aufeinanderfolgender Wortleitungen (4) eine seitliche Beschichtung (15) bereitgestellt ist, **dadurch gekennzeichnet, dass** die seitliche Beschichtung wenigstens eine leitende Schwebepotentialschicht (16) und eine dünne Isolierschicht (17) umfasst, wobei die dünne Isolierschicht (17) zwischen der oberen Oberfläche des Halbleitersubstrats (3) und der leitenden Schwebepotentialschicht (16) angeordnet ist.

2. Vorrichtung nach Anspruch 1, **dadurch gekennzeichnet, dass** die Beschichtung (15) seitlich auf den Zellen (2) entlang der Richtung der Bitleitungen (5) geformt ist.

3. Vorrichtung nach Anspruch 1, **dadurch gekennzeichnet, dass** die Beschichtung (15) auf den Wortleitungen (4) entlang der Richtung der Bitleitungen (5) geformt ist.

4. Vorrichtung nach einem der vorstehenden Ansprüche, **dadurch gekennzeichnet, dass** die dünne Isolierschicht (17) zwischen den Floating-Gate-Bereichen (9) und der wenigstens einen leitenden Schicht (16) entlang der Richtung der Bitleitungen (5) angeordnet ist.

5. Vorrichtung nach einem der Ansprüche 1 oder 4, umfassend eine Silizidschicht (11), die über den Steuer-Gate-Bereichen (12) angeordnet ist, die mit den darunter liegenden Floating-Gate-Bereichen (9) eine Mehrzahl von Strukturen (25) verwirklicht, die seitliche Distanzstücke (22) in Richtung der Bitleitungen (5) aufweisen, **dadurch gekennzeichnet, dass** die Beschichtung (15) die Strukturen (25) und/oder die Distanzstücke (22) von oben und/oder seitlich abdeckt.

6. Vorrichtung nach einem der Ansprüche 1 oder 4, umfassend eine Silizidschicht (11), die über den Steuer-Gate-Bereichen (12) angeordnet ist, die mit den Floating-Gate-Bereichen (9) eine Mehrzahl von Strukturen (25) verwirklichen, **dadurch gekennzeichnet, dass** die Beschichtung (15) die Strukturen (25) wenigstens seitlich bedeckt, wobei die Beschichtung (15) die dünne Isolierschicht (17) und die leitende Schicht (16) umfasst, die seitlich auf den darunterliegenden Strukturen (25) entlang der Richtung der Bitleitungen (5) geformt sind, und **dadurch**, dass sie eine Distanzschicht (26) aufweist, die über der Beschichtung (15) angeordnet ist, die das Substrat (3) vollständig abdeckt.

7. Vorrichtung nach einem der vorstehenden Ansprüche, einen Wähltransistor (20) umfassend, **dadurch gekennzeichnet, dass** die Beschichtung (15) den Wähltransistor (20) teilweise abdeckt.

8. Vorrichtung nach einem der vorstehenden Ansprüche, **dadurch gekennzeichnet, dass** die leitende Schicht (16) eine Polysiliziumschicht ist.

9. Vorrichtung nach einem der vorstehenden Ansprüche, **dadurch gekennzeichnet, dass** die leitende Schicht (16) ein hochschmelzendes Metall ist.

10. Vorrichtung nach einem der vorstehenden Ansprüche, **dadurch gekennzeichnet, dass** die leitende Schicht (16) eine Titanschicht ist.

11. Vorrichtung nach einem der vorstehenden Ansprüche, **dadurch gekennzeichnet, dass** die dünne Isolierschicht (17) ein Siliziumnitrid ist.

12. Vorrichtung nach einem der vorstehenden Ansprüche, **dadurch gekennzeichnet, dass** die dünne Isolierschicht (17) ein Siliziumoxid ist.

13. Vorrichtung nach einem der vorstehenden Ansprüche, **dadurch gekennzeichnet, dass** die dünne Isolierschicht (17) mittels eines Abscheidungsprozesses erhalten wird.

14. Vorrichtung nach einem der vorstehenden Ansprüche, **dadurch gekennzeichnet, dass** die dünne Isolierschicht (17) mittels eines Wachstumsprozesses erhalten wird.

## Revendications

1. Dispositif de mémoire électronique comprenant des cellules de mémoire non volatile, ayant une densité élevée et une interférence de cellule à cellule réduite, du type intégré sur un substrat semi-conducteur (3) et organisé en une matrice avec des rangées ou lignes de mot (4) et des colonnes ou lignes de bit (5) de cellules de mémoire (2), chacune desdites cellules (2) comprenant au moins un transistor à grille flottante comportant une région de grille flottante (9) faisant saillie dudit substrat (3) et une région de grille de commande (12) couplée capacitivement à ladite région de grille flottante (9), dans lequel, entre lesdites cellules (2) de lignes de mot (4) consécutives, un revêtement latéral (15) est prévu, **caractérisé en ce que** ledit revêtement latéral comprend au moins une couche conductrice flottante (16) et une couche mince isolante (17), ladite couche mince isolante (17) étant interposée entre la surface supérieure du substrat semi-conducteur (3) et ladite couche conductrice flottante (16).

2. Dispositif selon la revendication 1, **caractérisé en ce que** ledit revêtement (15) est formé latéralement sur lesdites cellules (2) le long de la direction desdites lignes de bit (5).

3. Dispositif selon la revendication 1, **caractérisé en ce que** ledit revêtement (15) est formé sur lesdites lignes de mot (4) le long de la direction desdites lignes de bit (5).

4. Dispositif selon une ou plusieurs des revendications précédentes, **caractérisé en ce que** ladite mince couche isolante (17) est interposée entre lesdites régions de grille flottante (9) et ladite au moins une couche conductrice (16) le long de la direction desdites lignes de bit (5).

5. Dispositif selon la revendication 1 ou 4, comprenant une couche de siliciure (11) agencée au-dessus desdites régions de grille de commande (12) réalisant avec lesdites régions de grille flottante (9) sous-jacentes une pluralité de structures (25) comportant des éléments d'espacement (22) latéraux dans la direction desdites lignes de bit (5), **caractérisé en ce que** ledit revêtement (15) recouvre le dessus et/ou les côtés desdites structures (25) et/ou desdits éléments d'espacement (22).

6. Dispositif selon la revendication 1 ou 4, comprenant une couche de siliciure (11) agencée au-dessus desdites régions de grille de commande (12) réalisant avec lesdites régions de grille flottante (9) une pluralité de structures (25), **caractérisé en ce que** ledit revêtement (15) recouvre au moins latéralement lesdites structures (25), ledit revêtement (15) comprenant ladite couche mince isolante (17) et ladite couche conductrice (16) formées sur les côtés desdites structures (25) sous-jacentes dans la direction desdites lignes de bit (5), et **en ce qu'**il comporte une couche d'espacement (26) agencée au-dessus dudit revêtement (15) recouvrant complètement ledit substrat (3).

7. Dispositif selon une ou plusieurs des revendications précédentes, du type comprenant des transistors de sélection (20), **caractérisé en ce que** ledit revêtement (15) recouvre partiellement lesdits transistors de sélection (20).

8. Dispositif selon une ou plusieurs des revendications précédentes, **caractérisé en ce que** ladite couche conductrice (16) est une couche de silicium polycristallin.

9. Dispositif selon une ou plusieurs des revendications précédentes, **caractérisé en ce que** ladite couche conductrice (16) consiste en un métal réfractaire.

10. Dispositif selon une ou plusieurs des revendications précédentes, **caractérisé en ce que** ladite couche conductrice (16) est une couche de titane.

11. Dispositif selon une ou plusieurs des revendications précédentes, **caractérisé en ce que** ladite couche mince isolante (17) consiste en du nitrure de silicium.

12. Dispositif selon une ou plusieurs des revendications précédentes, **caractérisé en ce que** ladite couche mince isolante (17) consiste en un oxyde de silicium.

13. Dispositif selon une ou plusieurs des revendications précédentes, **caractérisé en ce que** ladite couche mince isolante (17) est obtenue au moyen d'un procédé de dépôt.

14. Dispositif selon une ou plusieurs des revendications précédentes, **caractérisé en ce que** ladite couche mince isolante (17) est obtenue au moyen d'un procédé de croissance.
